# EUROPÄISCHE PATENTSCHRIFT

(11) **EP 2 485 028 B1**
(45) Veröffentlichungstag und Bekanntmachung des Hinweises auf die Patenterteilung: **01.04.2015**
(21) Anmeldenummer: 11153549.8
(22) Anmeldetag: 07.02.2011
(51) Int. Cl.: G01L 9/06, G01L 9/12

(54) **Druckempfindliche Verstärkerstufe**
Pressure-sensitive amplifier stage
Etage amplificateur sensible à la pression

(43) Veröffentlichungstag der Anmeldung: 08.08.2012
(73) Patentinhaber: ELMOS Semiconductor AG, 44227 Dortmund (DE)
(72) Erfinder: Büsser, Wolfgang, 44227, Dortmund (DE)
(74) Vertreter: Von Kreisler Selting Werner - Partnerschaft von Patentanwälten und Rechtsanwälten mbB

(56) Entgegenhaltungen:
- EP-A1- 0 006 740
- US-A- 5 225 705

## Beschreibung

Die Erfindung betrifft eine druckempfindliche Verstärkerstufe mit einer modifizierten Wheatstone-Brücke.

Es ist bekannt, mikromechanische Drucksensoren durch die Verschaltung von MOS-Transistoren nach Art einer Wheatstoneschen Brücke zu verschalten. Derartige Brückenschaltungen sind beispielsweise in EP-A-0 006 740, EP-B-1 152 232 (DE-T-699 17 943), US-A-4 275 406, US-A-4 459 856, US-A-4 522 072, DE-C-43 11 298, DE-A-44 44 808 und DE-U-78 28 255 beschrieben.

Beim Einsatz von MOS-Transistoren als Drucksensoren in mikromechanischen Sensoren besteht üblicherweise die Notwendigkeit der Kombination der Ausgangssignale mehrere derartiger nach Art einer Wheatstoneschen Brücke verschalteter Drucksensoren, um beispielsweise die Einflüsse von mechanischen Gehäusespannungen auf die Messgröße zu reduzieren bzw. zu unterdrücken. Die einzelnen nach Art einer Wheatstoneschen Brücke verschalteten Drucksensoren werden dabei üblicherweise in einer Kombination aus Reihen- und Parallelschaltungen verschaltet. Diese Kombination der Ausgangssignale mehrerer Wheatstonescher Brücken erfolgt dabei üblicherweise derart, dass die Brücken je nach gewünschter Polarität parallel oder antiparallel geschaltet werden. Diese Anordnungen haben den Nachteil, dass das Gesamtnutzsignal der Kombination der mehreren zuvor genannten Wheatstoneschen Brücken das Nutzsignal eines einzelnen Drucksensors bzw. einer einzelnen Wheatstoneschen Brücke nicht übertrifft. Mit anderen Worten erfolgt also eine Mittelung der Signalstärke und nicht etwa eine Addition, die aber wünschenswert wäre.

Aufgabe der Erfindung ist es, eine druckempfindliche Verstärkerstufe zu schaffen, die kaskadierbar ist.

Zur Lösung dieser Aufgabe wird mit der Erfindung eine kaskadierbare druckempfindliche Verstärkerstufe nach Anspruch 1 geschaffen. Einzelne Ausgestaltungen der Erfindung sind Gegenstand der Unteransprüche.

Wie jede übliche Wheatstonesche Brücke aus Drucksensoren weist auch die erfindungsgemäße druckempfindliche Verstärkerstufe vier Drucksensoren auf, die in Form unipolarer Drucksensor-Transistoren ausgeführt sind. Bei diesen Transistoren handelt es sich also um Feldeffekttransistoren, die als PMOS-, NMOS- oder JFET-Transistoren ausgebildet sind.

Die erfindungsgemäßen Drucksensor-Transistoren sind für mechanische (Ver-) Spannungen empfindlich (nachfolgend auch mit druckempfindlich bezeichnet) und können beispielsweise piezoresistiv oder kapazitiv arbeiten. Jeder dieser Transistoren weist einen Steueranschluss sowie einen weiteren ersten und einen weiteren zweiten Anschluss auf, zwischen denen sich ein druckempfindlicher Strompfad erstreckt, der durch Anlegen einer Betriebsspannung an dem Steueranschluss aktiviert wird. Die vier Drucksensoren sind als Druckmessbrücke mit zwei Brückenzweigen verschaltet.

Zwischen den beiden Brückenzweigen sind zwei unipolare Steuer-Transistoren geschaltet, von denen jeder einen Steueranschluss und einen sich zwischen einem weiteren ersten und einem weiteren zweiten Anschluss erstreckenden Strompfad aufweist. Die weiteren ersten Anschlüsse der beiden Steuer-Transistoren sind untereinander verbunden. Genauso sind auch die weiteren zweiten Anschlüsse der beiden Steuer-Transistoren untereinander verbunden. Die Steueranschlüsse der beiden Steuer-Transistoren sind mit jeweils einem anderen der beiden Knotenpunkte zwischen den Drucksensor-Transistoren der Brückenzweige verbunden. Damit werden die beiden Steuer-Transistoren durch die Potentiale an den Knotenpunkten der beiden Brückenzweige gesteuert.

Die miteinander verbundenen zweiten Anschlüsse der beiden bezüglich ihrer Strompfade parallel geschalteten Steuer-Transistoren sind mit den Steueranschlüssen der zweiten Drucksensor-Transistoren der beiden Brückenzweige verbunden, während die miteinander verbundenen ersten Anschlüsse der beiden parallel geschalteten Steuer-Transistoren mit den verbundenen ersten Anschlüssen der beiden ersten Drucksensor-Transistoren der Brückenzweige verbunden sind. Die jeweils miteinander verbundenen Enden der Brückenzweige sind mit einer ersten bzw. einer zweiten Stromquelle verbunden, von denen jede ihrerseits an einer ersten bzw. einer zweiten Versorgungsspannung anliegt. Über beispielsweise die erste Stromquelle wird in die Brückenschaltung ein Strom eingespeist, der sich auf die beiden Brückenzweige und auf die beiden parallel geschalteten Steuer-Transistoren aufteilt. Hinter den beiden Steuer-Transistoren sowie am Ende der beiden Brückenzweige fließen die Ströme zur zweiten Versorgungsspannung bzw. zur zweiten Stromquelle hin ab. Wird nun an die Steueranschlüsse der ersten Drucksensor-Transistoren der beiden Brückenzweige eine Betriebsspannung angelegt, so kann an den Knotenpunkten der beiden Brückenzweige eine Ausgangsspannung abgegriffen werden, die die Messausgangsspannung bildet. Diese Messausgangsspannung kann nun zwecks Kaskadierung mehrere der erfindungsgemäßen druckempfindlichen Verstärkerstufen an die Steueranschlüsse der ersten Drucksensor-Transistoren einer weiteren Verstärkerstufe angelegt werden.

Mit dem erfindungsgemäßen Konzept der Verschaltung einer Wheatstoneschen Messbrücke aus vier Drucksensor-Transistoren mit den beiden Steuer-Transistoren und den Stromquellen in der zuvor beschriebenen Anordnung ist es möglich, dass trotz Kaskadierung jede druckempfindliche Verstärkerstufe mit der gleichen Betriebseingangsspannung an den ersten Drucksensor-Transistoren der Messbrücke versorgt wird. Es erfolgt also keine Abschwächung des Messsignals. Damit findet eine Addition (bzw. Subtraktion) der Nutzsignale statt, wodurch der Messbereich erweitert und das Signal-zu-Rausch-Verhältnis vergrößert werden kann.

In vorteilhafter Weiterbildung der Erfindung ist vorgesehen, dass die Drucksensor-Transistoren und die Steuer-Transistoren im Wesentlichen gleich skaliert sind und dass die Größe des ersten Stroms im Wesentlichen das Doppelte der Größe des zweiten Stroms beträgt. Damit verteilt sich der beispielsweise von der ersten Stromquelle eingeprägte Strom gleichmäßig auf die beiden Brückenzweige und die beiden parallel geschalteten Steuer-Transistoren. Durch jeden Brückenzweig fließt dann 1/4 des eingeprägten Stroms, während durch die beiden parallel geschalteten Steuer-Transistoren die Hälfte des eingeprägten Stromes fließt. Selbstverständlich ist die Erfindung auf eine derartige Skalierung der Transistoren nicht beschränkt. Bei einer anderen Schaltungselement-Skalierung als der zuvor genannten verteilt sich der von der ersten Stromquelle erzeugte Strom dann anders. Demzufolge ist dann auf die Größe des von der zweiten Stromquelle erzeugten Stroms anzupassen.

Bei einer weiteren vorteilhaften Ausgestaltung der Erfindung ist das Verhältnis aus der Differenz des ersten und zweiten Stroms zum zweiten Strom so gewählt wie die Skalierung jedes der ersten Drucksensor-Transistoren der beiden Brückenzweige im Verhältnis zu jedem der beiden Steuer-Transistoren.

Schließlich kann zur Schwingungsverhinderung bzw. -dämpfung der Druckmessbrücke zwischen den Steueranschlüssen der zweiten Drucksensor-Transistoren der beiden Brückenzweige und der zweiten Versorgungsspannung eine Kapazität geschaltet sein.

Die erfindungsgemäße druckempfindliche Verstärkerstufe weist vier für mechanische Spannungen empfindliche Transistoren, nämlich die (Druck-) Sensor-Transistoren, und zwei nicht druckempfindliche Transistoren, nämlich die Steuer-Transistoren auf. Die Steuer-Transistoren dienen der Aufrechterhaltung eines Common-Mode-Potential, was bedeutet, dass jede kaskadierte druckempfindliche Verstärkerstufe an den Steueranschlüssen der ersten Drucksensor-Transistoren der Brückenzweige mit der gleichen Betriebseingangsspannung versorgt werden.

Bei den vier Drucksensor-Transistoren handelt es sich zweckmäßigerweise um PMOS-Transistoren. Auch die beiden Steuer-Transistoren sind zweckmäßigerweise als PMOS-Transistoren ausgebildet. Die erste Stromquelle kann ebenfalls mit einem PMOS-Transistor versehen sein, während die zweite Stromquelle einen NMOS-Transistor aufweist. Allgemein kann zu den beiden Spannungsquellen gesagt werden, dass diese unpolaren Transistoren unterschiedliche Polarität aufweisen, da die eine Stromquelle einen Strom in die Brückenschaltung einprägt und die andere Stromquelle den aus der Brückenschaltung abfließenden Strom aufnimmt.

Mit "Drucksensor-Transistor" ist vorstehend ein Transistor bezeichnet, dessen steuerbarer Strompfad für mechanische Spannungen sensitiv ist, wie sie z.B. bei auf den Transistor wirkenden hydraulischen, hydrostatischen, pneumatischen oder mechanischen Drücken entstehen.

Die Erfindung wird nachfolgend anhand eines Ausführungsbeispiels und unter Bezugnahme auf die Zeichnung näher erläutert. Im Einzelnen zeigen dabei:
- Fig. 1: die Verschaltung einer einzelnen druckempfindlichen Verstärkerstufe gemäß einem Ausführungsbeispiel der Erfindung und
- Fig. 2: die Kaskadierung zweier druckempfindlicher Verstärkerstufen gemäß Fig. 1 durch Hintereinanderschaltung der beiden Verstärkerstufen.

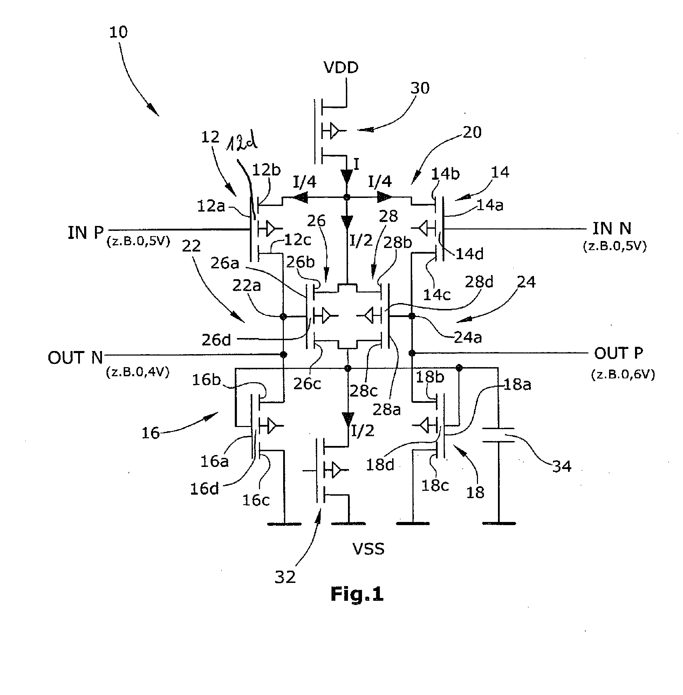

In Fig. 1 ist der allgemeine Aufbau einer druckempfindlichen Verstärkerstufe 10 gezeigt. Die druckempfindliche Verstärkerstufe 10 weist vier druckempfindliche Transistoren (Drucksensor-Transistoren) 12,14,16,18 auf, die nach Art einer Wheatstoneschen Brücke 20 mit zwei Brückenzweigen 22,24 verschaltet sind. Jeder Drucksensor-Transistor 12,14,16,18 weist einen Steueranschluss 12a,14a,16a bzw. 18a sowie zwei weitere Anschlüsse 12b und 12c, 14b und 14c,16b und 16c bzw. 18b und 18c auf, zwischen denen sich jeweils ein in diesem Ausführungsbeispiel piezoresistiver Strompfad 12d,14c,16d und 18d erstreckt. Die vier Drucksensor-Transistoren sind beispielsweise als PMOS-Transistoren ausgeführt. Zwischen den Knotenpunkten 22a,24a der beiden Brückenzweige 22,24 sind zwei Steuer-Transistoren 26,28 geschaltet, deren nicht druckempfindliche Strompfade 26d,28d parallel geschaltet sind. Die beiden Steueranschlüsse 26a und 28a sind mit den Knotenpunkten 22a,24a jeweils eines verschiedenen Brückenzweiges 22,24 verbunden. Die weiteren ersten Anschlüsse 26b und 28b der beiden Steuer-Transistoren 26 und 28 sind untereinander verbunden; ebenso sind die weiteren zweiten Anschlüsse 26c und 28c der beiden Steuer-Transistoren 26 und 28 miteinander verbunden. Die beiden ersten Anschlüsse 26b und 28b sind zusätzlich mit den ersten weiteren Anschlüssen 12b und 14b der beiden ersten Drucksensor-Transistoren 12,14 der Brückenzweige 22,24 verbunden. Die beiden weiteren zweiten Anschlüsse 26c und 28c der Steuer-Transistoren 26 oder 28 sind mit jeweils einem verschiedenen der beiden Steueranschlüsse 16a,18a der beiden zweiten Drucksensoren 16,18 verbunden.

Zwischen einem Versorgungspotential VDD und den beiden ersten Drucksensor-Transistoren 12 und 14 der Druckmessbrücke 20 ist eine erste Stromquelle 30 zur Erzeugung eines Stroms I geschaltet, während mit den weiteren zweiten Anschlüssen 26c,28c der Steuer-Transistoren 26,28 eine weitere zweite Stromquelle 32 geschaltet ist, die von einem zweiten Versorgungspotential VSS versorgt wird. Ferner ist die Druckmessbrücke 20 über eine Kapazität 34 mit dem zweiten Versorgungspotential verbunden, wie es in Fig. 1 gezeigt ist.

Die beiden Stromquellen 30,32 sind beispielsweise ebenfalls durch MOS-Transistoren entgegengesetzter Leitungstypen realisiert.

Die Dimensionierung der Stromquellen 30 und 32 sowie die Skalierung der Drucksensor-Transistoren 12,14,16 und 18 sowie der Steuer-Transistoren 26,28 ist derart gewählt, dass die Hälfte des von der ersten Stromquelle 30 eingeprägten Stroms I über die Strompfade 26d,28d der Steuer-Transistoren fließt, während jeweils ¼ des Stroms über jeden der beiden Brückenzweige 22,24 fließt. Wird nun an die Steueranschlüsse 12a und 14a der beiden ersten Drucksensor-Transistoren 12,14 eine Betriebseingangsspannung INP bzw. INN angelegt (beispielsweise jeweils 0,5 Volt), so fällt über den beiden ersten Drucksensor-Transistoren 12,14 auch in Abhängigkeit von dem örtlich wirkenden Druck eine Spannung ab, wobei das Potential hinter den beiden Transistoren über die Knotenpunkte 22a,24a zur Steuerung der beiden Steuer-Transistoren 26,28 genutzt wird, und zwar dergestalt, dass am Ausgang OUTN und OUTP im Mittel wieder die gleiche Spannung anliegt (beispielsweise 0,4 Volt an OUTN und 0,6 Volt an OUTP). Im Mittel ist also die Ausgangsspannung genauso groß wie die Eingangsspannung. Der Unterschied in der Differenz der Potentiale an OUTN und OUTP im Vergleich zu INP und INN ist repräsentativ für den gemessenen Druck bzw. die gemessenen mechanischen Spannungen, die auf die Druckmessbrücke 20 einwirken.

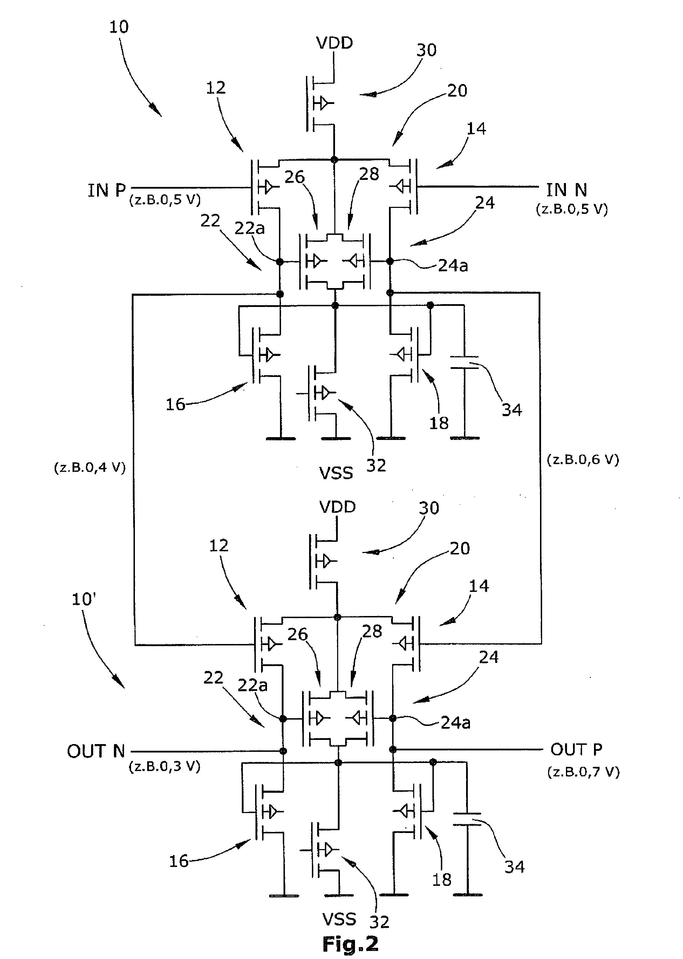

Wie oben gezeigt, führt also die druckempfindliche Verstärkerstufe 10 ein unverändertes Common-Mode-Potential von ihrem Eingang (an INP und INN) zu ihrem Ausgang (OUTN und OUTP). Dies ermöglicht es nun, mehrere Verstärkerstufen 10 nach Fig. 1 zu kaskadieren, wie es beispielsweise in Fig. 2 gezeigt ist. In Fig. 2 ist darüber hinaus ein Beispiel für eine mögliche weiter vergrößerte Spannungsdifferenz am Ausgang der zweiten Verstärkerstufe 10' gezeigt (OUTN beispielsweise 0,3 Volt und OUTP beispielsweise 0,7 Volt). Wieder zeigt sich, dass das Common-Mode-Potential (Mittelwert der Spannungen an OUTN und OUTP) gleichgeblieben ist. Die erfindungsgemäße druckempfindliche Verstärkerstufe nutzt die Drucksensor-Transistoren 12,14,16 und 18 selbst zur Verstärkung des Nutzsignals, so dass die Verstärkerstufen kaskadiert werden können und sich die Nutzsignale addieren. Dazu bleibt die eigentliche Wheatstonesche Brücke (Druckmessbrücke 20) unverändert. Lediglich die Steueranschlüsse 12a,14a,16a und 18a der vier Drucksensor-Transistoren 12,14,16 und 18 sind anders zu verschalten und es sind einige weitere, nicht druckempfindliche Transistoren, nämlich die beiden Steuer-Transistoren 26,28 (und bei Ausführung der Stromquellen 30,32 durch Transistoren) hinzuzufügen. Die erfindungsgemäße Schaltung wurde anhand eines Ausführungsbeispiels vorstehend unter Bezugnahme auf die Fign. 1 und 2 erläutert. In dem Ausführungsbeispiel ist eine Anordnung gezeigt, bei der die vier Drucksensor-Transistoren 12,14,16 und 18 bei gleicher Dimensionierung eine Differenz-Verstärkung von eins realisieren. Die Steuer-Transistoren 26,28 steuern zusammen mit den Stromquellen 30,32 die Steueranschlüsse der zweiten Drucksensor-Transistoren 16,18 der beiden Brückenzweige 22,24 derart an, dass das Ausgangs-Common-Mode-Potential (V_{OUTN} + V_{OUTP})/2 dem Eingangs-Common-Mode-Potential (V_{INN} + V_{INP})/2 entspricht. Dadurch lassen sich unterschiedliche Stufen durch Verbinden von INN, INP an OUTN und OUTP bzw. an OUTP, OUTN unter Addition der druckabhängigen Signale kaskadieren.

Die beschriebene Kombination mehrerer kaskadierter druckempfindlicher Verstärkerstufen 10 kann je nach Einsatz beispielsweise als Eingangsstufe eines druckempfindlichen Operationsverstärkers dienen. Alternativ kann das kombinierte Signal auch an der letzten Stufe abgegriffen werden bzw. einem ADC (evtl. nach weiterer Zwischenverstärkung) zugeführt werden.

### BEZUGSZEICHENLISTE

- 10: druckempfindliche Verstärkerstufe
- 10': kaskadierte Verstärkerstufe
- 12: Drucksensor-Transistor
- 12a: Steuer-(Gate-)Anschluss des Drucksensor-Transistors
- 12b: weiterer (Drain-)Anschluss des Drucksensor-Transistors
- 12c: weiterer (Source-)Anschluss des Drucksensor-Transistors
- 12d: Strompfad des Drucksensor-Transistors
- 14: Drucksensor-Transistor
- 14a: Steuer-(Gate-)Anschluss des Drucksensor-Transistors
- 14b: weiterer (Drain-)Anschluss des Drucksensor-Transistors
- 14c: weiterer (Source-)Anschluss des Drucksensor-Transistors
- 16: Drucksensor-Transistor
- 16a: Steuer-(Gate-)Anschluss des Drucksensor-Transistors
- 16b: weiterer (Drain-)Anschluss des Drucksensor-Transistors
- 16c: weiterer (Source-)Anschluss des Drucksensor-Transistors
- 16d: Strompfad des Drucksensor-Transistors
- 18: Drucksensor-Transistor
- 18a: Steuer-(Gate-)Anschluss des Drucksensor-Transistors
- 18b: weiterer (Drain-)Anschluss des Drucksensor-Transistors
- 18c: weiterer (Source-)Anschluss des Drucksensor-Transistors
- 18d: Strompfad des Drucksensor-Transistors
- 20: Druckmessbrücke
- 22: Brückenzweig der Druckmessbrücke
- 22a: Knotenpunkte im Brückenzweig
- 24: Brückenzweig der Druckmessbrücke
- 24a: Knotenpunkt im Brückenzweig
- 26: Steuer-Transistor
- 26a: Steuer-(Gate-)Anschluss des Steuer-Transistors
- 26b: erster (Drain-)Anschluss des Steuer-Transistors
- 26c: zweiter (Source-)Anschluss des Steuer-Transistors
- 26d: Strompfad des Steuer-Transistors
- 28: Steuer-Transistor
- 28a: Steuer-(Gate-)Anschluss des Steuer-Transistors
- 28b: erster (Drain-)Anschluss des Steuer-Transistors
- 28c: zweiter (Source-)Anschluss des Steuer-Transistors
- 28d: Strompfad des Steuer-Transistors
- 30: erste Stromquelle
- 32: zweite Stromquelle
- 34: Kapazität

## Patentansprüche

1. Druckempfindliche Verstärkerstufe mit
- vier unipolaren Drucksensor-Transistoren (12,14,16,18) mit jeweils einem Steueranschluss und einem sich zwischen einem weiteren ersten und einem weiteren zweiten Anschluss (12b,12c,14b,14c,16b, 16c,18b,18c) angeordneten für mechanische Spannungen empfindlichen Strompfad (12d,14d,16d, 18d),
- wobei die vier Drucksensor-Transistoren (12,14,16,18) als Druckmessbrücke (20) mit zwei Brückenzweigen (22,24) verschaltet sind, die jeweils einen ersten und einen zweiten, bezüglich ihrer Strompfade in Reihe geschalteten Drucksensor-Transistor (12,16 bzw. 14,18) aufweisen,
gekennzeichnet durch
- zwei unipolare Steuer-Transistoren (26,28) mit jeweils einem Steueranschluss (26a,26b) und einem sich zwischen einem weiteren ersten und einem weiteren zweiten Anschluss (26b,26c;28b,28c) erstreckenden Strompfad (26d,28d),
- wobei jeweils die ersten und die zweiten Anschlüsse (26b,26c;28b,28c) der beiden Steuer-Transistoren (26,28) paarweise verbunden sind sowie die Steueranschlüsse (26a,28a) der Steuer-Transistoren (26,28) jeweils mit einem Knotenpunkt (22a,24a) zwischen den Drucksensor-Transistoren (12,16 bzw. 14,18) der beiden Brückenzweige (22,24) verbunden sind und
- wobei die untereinander verbundenen zweiten Anschlüsse (26c,28c) der beiden parallel geschalteten Steuer-Transistoren (26,28) mit den Steueranschlüssen (16a,18a) der zweiten Drucksensor-Transistoren (16,18) der beiden Brückenzweige (22,24) verbunden sind,
- eine zwischen einer ersten Versorgungsspannung (VDD) einerseits und den ersten Anschlüssen (12b,14b) der ersten Drucksensor-Transistoren (12,14) der beiden Brückenzweige (22,24) sowie den miteinander verbundenen ersten Anschlüssen (26a,28a) der Steuer-Transistoren (26,28) andererseits geschalteten ersten Stromquelle (30) zum Erzeugen eines ersten Stroms (I) und
- einer zwischen einer zweiten Versorgungsspannung (VSS) einerseits und den miteinander verbundenen zweiten Anschlüssen (26c,28c) der Steuer-Transistoren (26,28) sowie den Steueranschlüssen (16a,18a) der zweiten Drucksensor-Transistoren (16,18) der beiden Brückenzweige (22,24) andererseits geschalteten zweiten Stromquelle (32) zum Erzeugen eines zweiten Stroms (I/2),
- wobei an die Steueranschlüsse (12a,14a) der ersten Drucksensor-Transistoren (12,14) der beiden Brückenzweige (22,24) jeweils eine Betriebseingangsspannung (INN,INP) anlegbar und zwischen den jeweiligen Drucksensor-Transistoren (12,16 bzw. 14,18) der beiden Brückenzweige (22,24) eine Messausgangsspannung (OUTN,OUTP) abgreifbar ist und
- wobei die Messausgangsspannung (OUTN, OUTP) der Druckmessbrücke (20) mit den Steueranschlüssen (12a,14a) der ersten Drucksensor-Transistoren (12,14) der beiden Brückenzweige (22,24) einer weiteren Druckmessbrücke (20) zur Kaskadierung der Druckmessbrücken (20) anlegbar ist.

2. Druckempfindliche Verstärkerstufe nach Anspruch 1, **dadurch gekennzeichnet, dass** die Drucksensor-Transistoren (12,14,16,18) und die Steuer-Transistoren (26,28) im Wesentlichen gleich skaliert sind und dass die Größe des ersten Stroms (I) im Wesentlichen das Doppelte der Größe des zweiten Stroms (1/2) beträgt.

3. Druckempfindliche Verstärkerstufe nach Anspruch 1, **dadurch gekennzeichnet, dass** das Verhältnis aus der Differenz des ersten und des zweiten Stroms (I,I/2) zum zweiten Strom (1/2) so gewählt ist wie die Skalierung jedes der ersten Drucksensor-Transistoren (12,14,16,18) der beiden Brückenzweige (22,24) im Verhältnis zu jedem der beiden Steuer-Transistoren (26,28).

4. Druckempfindliche Verstärkerstufe nach einem der Ansprüche 1 bis 3, **dadurch gekennzeichnet, dass** zwischen die Steueranschlüsse (16a,18a) der zweiten Drucksensor-Transistoren (16,18) der beiden Brückenzweige (22,24) und der zweiten Versorgungsspannung (VSS) eine Kapazität (34) zur Schwingungsverhinderung oder -dämpfung der Druckmessbrücke (20) geschaltet ist.

5. Druckempfindliche Verstärkerstufe nach einem der Ansprüche 1 bis 4, **dadurch gekennzeichnet, dass** die vier Drucksensor-Transistoren (12,16:14,18) jeweils als PMOS-Transistoren ausgebildet sind.

6. Druckempfindliche Verstärkerstufe nach einem der Ansprüche 1 bis 5, **dadurch gekennzeichnet, dass** die beiden Steuer-Transistoren (26,28) jeweils als PMOS-Transistoren ausgebildet sind.

## Claims

1. A pressure-sensitive amplifier stage comprising
- four unipolar pressure-sensor transistors (12,14,16,18), each comprising a control terminal and a current path (12d,14d,16d,18d) arranged between a further first and a further second terminal (12b, 12c,14b,14c,16b,16c,18b,18c), said current path being sensitive to mechanical tension,
- said four pressure-sensor transistors (12,14,16,18) being connected as a pressure-measuring bridge (20) having two bridge legs (22, 24), each of said bridge legs comprising a first and a second pressure-sensor transistor (12,16 and resp. 14,18) which are connected in series with respect to their current paths,
**characterized by**
- two unipolar control transistors (26,28), each having a control terminal (26a,26b) and a current path (26d,28d) arranged between a further first and a further second terminal (26b,26c;28b,28c),
- the respective first and second terminals (26b,26c;28b,28c) of said two control transistors (26,28) being connected in pairs, and the control terminals (26a,28a) of the control transistors (26,28) each being connected to a node (22a,24a) between the pressure-sensor transistors (12,16 and resp. 14,18) of the two bridge legs (22,24), and
- the interconnected second terminals (26c,28c) of the two parallel- connected control transistors (26,28) being connected to the control terminals (16a,18a) of the second pressure-sensor transistors (16, 18) of the two bridge legs (22,24),
- a first power source (30) connected between a first supply voltage (VDD) on the one hand, and the first terminals (12b,14b) of the first pressure-sensor transistors (12,14) of the two bridge legs (22,24) and the interconnected first terminals (26a,28a) of the control transistors (26,28) on the other hand, said first power source (30) being provided for generating a first current (I), and
- a second power source (32) connected between a second supply voltage (VSS) on the one hand, and the interconnected second terminals (26c,28c) of the control transistors (26,28) and the control terminals (16a,18a) of the second pressure-sensor transistors (16,18) of the two bridge legs (22,24) on the other hand, said second power source (32) being provided for generating a second current (I/2),
- the control terminals (12a,14a) of the first pressure-sensor transistors (12,14) of the two bridge legs (22,24) being adapted for connection thereto of a respective operating input voltage (INN, INP), and a measurement output voltage (OUTN,OUTP) being detectable between the respective pressure-sensor transistors (12,16 and resp. 14,18) of the two bridge legs (22,24), and
- said measurement output voltage (OUTN,OUTP) of the pressure-measuring bridge (20) being connectable to the control terminals (12a,14a) of the first pressure-sensor transistors (12,14) of the two bridge legs (22,24) of a further pressure-measuring bridge (20) for cascading the pressure-measuring bridges (20).

2. The pressure-sensitive amplifier stage of claim 1, **characterized in that** the pressure-sensor transistors (12,14,16,18) and the control transistors (26, 28) are substantially identically scaled and that the amount of the first current (I) is substantially twice the amount of the second current (I/2).

3. The pressure-sensitive amplifier stage of claim 1, **characterized in that** the ratio between the difference of the first and second currents (I,I/2) and the second current (I/2) is selected to correspond to the scaling of each of the first pressure-sensor transistors (12,14,16,18) of the two bridge legs (22,24) relative to each of the two control transistors (26,28).

4. The pressure-sensitive amplifier stage of any one of claims 1 to 3, **characterized in that**, for preventing or damping of the oscillation of the pressure measurement bridge (20), a capacitance (34) is connected between the control terminals (16a,18a) of the second pressure-sensor transistors (16,18) of the two bridge legs (22,24) and the second supply voltage (VSS).

5. The pressure-sensitive amplifier stage of any one of claims 1 to 4, **characterized in that** the four pressure-sensor transistors (12,16; 14, 18) are each designed as PMOS transistors.

6. The pressure-sensitive amplifier stage of any one of claims 1 to 5, **characterized in that** the two control transistors (26,28) are each designed as PMOS transistors.

## Revendications

1. Etage amplificateur sensible à la pression, comprenant :
- quatre transistors capteurs de pression (12, 14, 16, 18) unipolaires comprenant respectivement une borne de commande et un trajet de courant (12d, 14d, 16d, 18d) sensible aux contraintes mécaniques, disposé entre une première autre borne et une seconde autre borne (12b, 12c, 14b, 14c, 16b, 16c, 18b, 18c),
- les quatre transistors capteurs de pression (12, 14, 16, 18) étant montés en pont de mesure de pression (20) pourvu de deux branches de pont (22, 24), qui présentent respectivement un premier et un second transistor capteur de pression (12, 16 ou 14, 18) montés en série par rapport à leurs trajets de courant,
**caractérisé par**
- deux transistors de commande (26, 28) unipolaires comprenant respectivement une borne de commande (26a, 26b) et un trajet de courant (26d, 28d) s'étendant entre une première autre borne et une seconde autre borne (26b, 26c ; 28b, 28c),
- les premières et les secondes bornes (26b, 26c ; 28b, 28c) des deux transistors de commande (26, 28) étant respectivement reliées par paires, et les bornes de commande (26a, 28a) des transistors de commande (26, 28) étant respectivement reliées à un noeud (22a, 24a) entre les transistors capteurs de pression (12, 16 ou 14, 18) des deux branches de pont (22, 24), et
- les secondes bornes (26c, 28c) reliées entre elles des deux transistors de commande (26, 28) montés en parallèle étant reliées aux bornes de commande (16a, 18a) des seconds transistors capteurs de pression (16, 18) des deux branches de pont (22, 24),
- une première source de courant (30) montée entre une première tension d'alimentation (VDD), d'une part, et les premières bornes (12b, 14b) des premiers transistors capteurs de pression (12, 14) des deux branches de pont (22, 24) ainsi que les premières bornes (26a, 28a) reliées entre elles des transistors de commande (26, 28), d'autre part, pour générer un premier courant (I), et
- une seconde source de courant (32) montée entre une seconde tension d'alimentation (VSS), d'une part, et les secondes bornes (26c, 28c) reliées entre elles des transistors de commande (26, 28) ainsi que les bornes de commande (16a, 18a) des seconds transistors capteurs de pression (16, 18) des deux branches de pont (22, 24) d'autre part, pour générer un second courant (I/2),
- une tension d'entrée de service (INN, INP) pouvant être appliquée respectivement aux bornes de commande (12a, 14a) des premiers transistors capteurs de pression (12, 14) des deux branches de pont (22, 24) et une tension de sortie de mesure (OUTN, OUTP) pouvant être prélevée entre les transistors capteurs de pression (12, 16 ou 14, 18) respectifs des deux branches de pont (22, 24), et
- la tension de sortie de mesure (OUTN, OUTP) du pont de mesure de pression (20) pouvant être appliquée aux bornes de commande (12a, 14a) des premiers transistors capteurs de pression (12, 14) des deux branches de pont (22, 24) d'un autre pont de mesure de pression (20) pour la mise en cascade des ponts de mesure de pression (20).

2. Etage amplificateur sensible à la pression selon la revendication 1, **caractérisé en ce que** les transistors capteurs de pression (12, 14, 16, 18) et les transistors de commande (26, 28) sont mis à l'échelle de façon sensiblement identique et **en ce que** la valeur du premier courant (I) est sensiblement égale au double de la valeur du second courant (I/2).

3. Etage amplificateur sensible à la pression selon la revendication 1, **caractérisé en ce que** le rapport de la différence du premier et du second courant (I, I/2) au second courant (I/2) est choisi de façon à correspondre à la mise à l'échelle de chacun des premiers transistors capteurs de pression (12, 14, 16, 18) des deux branches de pont (22, 24) par rapport à chacun des deux transistors de commande (26, 28).

4. Étage amplificateur sensible à la pression selon l'une des revendications 1 à 3, **caractérisé en ce qu'**est montée entre les bornes de commande (16a, 18a) des seconds transistors capteurs de pression (16, 18) des deux branches de pont (22, 24) et la seconde tension d'alimentation (VSS), une capacité (34) destinée à éliminer ou amortir les vibrations du pont de mesure de pression (20).

5. Étage amplificateur sensible à la pression selon l'une des revendications 1 à 4, **caractérisé en ce que** les quatre transistors capteurs de pression (12, 16 ; 14, 18) sont conçus chacun en tant que transistors PMOS.

6. Étage amplificateur sensible à la pression selon l'une des revendications 1 à 5, **caractérisé en ce que** les deux transistors de commande (26, 28) sont conçus chacun en tant que transistors PMOS.
